# EUROPEAN PATENT APPLICATION

(11) **EP 2 194 593 A2**
(43) Date of publication of application: **09.06.2010**
(21) Application number: 09005717.5
(22) Date of filing: 23.04.2009
(51) Int. Cl.: H01L 51/50

(54) **Organic optoelectronic component**

(30) Priority: 04.12.2008 TW 97147068
(71) Applicant: National Chiao Tung University, Hsinchu (TW)
(72) Inventor: Meng, Hsin-Fei, Hsinchu (TW); Horng, Sheng-Fu, Hsinchu (TW); Tseng, Hsin-Rong, Hsinchu (TW); Li, Guan-Cheng National Chiao Tung University, Hsinchu (TW)
(74) Representative: Manitz, Finsterwald & Partner GbR

(57) **Abstract**

An organic optoelectronic component is provided, which includes a first electrode, an active layer formed on the first electrode, a second intermediate layer formed on the active layer, and a second electrode formed on the second intermediate layer, wherein the second intermediate layer is formed with a second mixture containing a second polymer and at least a second organic molecule. The second organic molecule is one for forming hole transferring material, electron transferring material, electron blocking material or hole blocking material. The organic optoelectronic component of the present invention is prepared by a solution process, thereby simplifying the process, improving film-formation property, and enhancing component efficiency.

## Description

### FIELD OF THE INVENTION

The invention relates to an organic optoelectronic component, more particularly, to an organic optoelectronic component having an intermediate layer having a mixture of a polymer and an organic molecule.

### BACKGROUND OF THE INVENTION

Optoelectronic components, such as light-emitting diodes, solar cells and light sensors, generate electromagnetic radiation or current, according to their optical properties or electronic properties.

For example, organic light sensors convert optical signals into electric signals by photosensitive components. Specifically, organic photosensitive materials in the organic light sensors absorb electromagnetic radiation to produce an excited molecular state, which is excitons having electron-hole pairs, and the so-called optoelectronic current is generated when the electron-hole pairs are separated.

Generally, layers with different functions are desired to facilitate carrier transfer or carrier block in order to achieve better component performance. For example, polymer materials are used as electron transferring layers or hole blocking layers in W09820565A1. However, the polymers can be considered as mixtures composed of repeating units having the same structure since they include a plurality of polymerized molecules having different chain lengths. When the polymers themselves are used for carrier transfer, for example, or even as active layers, it is difficult to control performance of the components due to the complicated structures of the polymers. Furthermore, an active layer composed of a polymer and a small molecule is disclosed in Advanced Functional Materials, 16, 611 (2006), and the aforementioned problem also occurs since the polymer is used for energy transformation. Additionally, the carrier transferring layer disclosed in the above paper is formed by evaporation of small molecules, which is unfavorable to the fabrication of components with a large area and incurs high costs.

Thus, a method, which is a simple process and is easy for manufacturing optoelectronic components with a large area, and organic optoelectronic components with enhanced efficiency and lowered costs are desired.

### SUMMARY OF THE INVENTION

To overcome the above-mentioned problems of the prior art, the present invention provides an organic optoelectronic component having an intermediate layer, which includes a mixture of a polymer and an organic molecule.

Further, the present invention provides an organic optoelectronic component with enhanced component efficiency.

Moreover, the present invention provides an organic light-emitting component.

Still, the present invention provides an organic light-sensing device.

In addition, the present invention provides an organic solar cell.

The organic optoelectronic component of the present invention includes: a first electrode; an active layer formed on the first electrode; a second intermediate layer formed on the active layer, allowing the active layer to be interposed between the first electrode and the second intermediate layer; and a second electrode formed on the second intermediate layer, allowing the second intermediate layer to be interposed between the active layer and the second electrode; wherein the second intermediate layer is formed with a second mixture containing a second polymer and at least a second organic molecule, and the at least a second organic molecule is one for forming hole transferring material, electron transferring material, electron blocking material or hole blocking material. It is preferred that the second polymer has a number average molecular weight ranging from 1,000 to 5,000,000. Furthermore, it is preferred that the second organic molecule has a molecular weight ranging from 50 to 1,000.

According to a second preferred embodiment, the aforementioned optoelectronic component further comprises a first intermediate layer formed between the active layer and the first electrode, wherein the first intermediate layer is formed with a first mixture containing a first polymer and at least a first organic molecule, and the at least a first organic molecule is one for forming hole transferring material, electron transferring material, electron blocking material or hole blocking material, and the second organic molecule is different from the first organic molecule. It is preferred that the first intermediate layer is a hole transferring layer and the second intermediate layer is one of an electron transferring layer and a hole blocking layer. Alternatively, the first intermediate layer may be an electron blocking layer and the second intermediate layer may be one of an electron transferring layer and a hole blocking layer.

In the aforementioned second embodiment, it is preferred that the first and the second polymers both have number average molecular weights ranging from 1,000 to 5,000,000. Furthermore, it is preferred that the first and the second organic molecules have molecular weights ranging from 50 to 1,000. Preferably, the first polymer is one for forming hole transferring material, electron transferring material, electron blocking material or hole blocking material.

In one aspect, the present invention further provides an organic light-emitting component, which employs the organic optoelectronic component of the present invention.

In another aspect, the present invention provides an organic light-sensing device, which includes the organic optoelectronic component of the present invention and a current sensing component electrically connected with the optoelectronic component.

In a further aspect, the present invention provides an organic solar cell, in which the organic optoelectronic component of the present invention is used for absorbing electromagnetic radiation to generate current.

Furthermore, the present invention further provides a method for manufacturing an organic optoelectronic component. The method comprises the steps of: providing a first electrode; applying onto the first electrode a first mixture which is dissolved in a first solvent and includes a first polymer and a first organic molecule, allowing the first mixture to form a first intermediate layer on the first electrode; removing the first solvent from the first intermediate layer, followed by forming an active layer on the first intermediate layer; and forming a second electrode on the active layer, allowing the active layer to be interposed between the first intermediate layer and the second electrode; wherein the first organic molecule is one for forming hole transferring material, electron transferring material, electron blocking material or hole blocking material.

An organic optoelectronic component formed by the above-mentioned method includes: a first electrode; a first intermediate layer formed on the first electrode; an active layer formed on the first intermediate layer, allowing the first intermediate layer to be interposed between the first electrode and the active layer; and a second electrode formed on the active layer, allowing the active layer to be interposed between the first intermediate layer and the second electrode; wherein the first intermediate layer is formed with a first mixture containing a first polymer and a first organic molecule, and the first organic molecule is one for forming hole transferring material, electron transferring material, electron blocking material or hole blocking material.

In another aspect, the present invention further provides a method for manufacturing an organic optoelectronic component. The method comprises the steps of: providing a first electrode; forming an active layer on the first electrode; applying onto the first electrode a second mixture which is dissolved in a second solvent and includes a second polymer and at least a second organic molecule, allowing the second mixture to form a second intermediate layer on the first electrode; removing the second solvent from the second intermediate layer, followed by forming an active layer on the second intermediate layer; and forming a second electrode on the active layer, allowing the active layer to be interposed between the second intermediate layer and the second electrode; wherein the at least a second organic molecule is one for forming hole transferring material, electron transferring material, electron blocking material or hole blocking material.

The present invention combines the optoelectronic property of the organic molecule and the film-formation property of the polymer, provides the manufacture of the organic optoelectronic component of the present invention by a solution process, simplifies the process and enhances the component efficiency.

### BRIEF DESCRIPTION OF DRAWINGS

FIG. 1A is a cross-sectional view of an organic optoelectronic component of the present invention;
FIG. 1B is a cross-sectional view of another organic optoelectronic component of the present invention;
FIG. 2 is a cross-sectional view of still another organic optoelectronic component of the present invention;
FIG. 3 is a graph showing the voltage versus the current density of an organic light-emitting component;
FIG. 4 is a comparative graph showing the voltage versus the current efficiency of an organic light-emitting component, in which TPBi is the hole blocking material;
FIG. 5 is a graph showing the voltage versus the current efficiency of an organic light-emitting component, in which PBD is the hole blocking material; and
FIG. 6 is a comparative graph showing the current efficiency between components fabricated by film coating and evaporation, respectively.

### DETAILED DESCRIPTION OF THE PREFERRED EMBODIMENTS

The following specific embodiments are provided to illustrate the disclosure of the present invention. These and other advantages and effects can be easily understood by those skilled in the art after reading the disclosure of this specification.

It is well known that the desired layers, e.g., carrier transferring layers, of organic optoelectronic components are formed by vacuum evaporation, and thus it is difficult to fabricate components with a large size. To solve the above-mentioned problem, the present invention provides a method for fabricating an organic optoelectronic component, comprising the steps of: applying onto a first electrode a first mixture which is dissolved in a first solvent and comprises a first polymer and a first organic molecule, allowing the first mixture to form a first intermediate layer on the first electrode; removing the first solvent from the first intermediate layer, followed by forming an active layer on the first intermediate layer; and forming a second electrode on the active layer, allowing the active layer to be interposed between the first intermediate layer and the second electrode; wherein the first organic molecule is one for forming hole transferring material, electron transferring material, electron blocking material or hole blocking material.

Alternatively, in another aspect, the invention further provides a method for fabricating an organic optoelectronic component. The method comprises the steps of: forming an active layer on a first electrode; applying onto the active layer a second mixture which is dissolved in a second solvent and comprises a second polymer and at least a second organic molecule, so as for the second mixture to form a second intermediate layer on the active layer, wherein the at least a second organic molecule is one for forming hole transferring material, electron transferring material, electron blocking material or hole blocking material; and forming a second electrode on the second intermediate layer.

The first solvent of the present invention is selected from those in which the first polymer and/or the first organic molecule can be dissolved, preferably, the first solvent is selected from those in which the first polymer and the first organic molecule can be dissolved, and more preferably, the first polymer and the first organic molecule are miscible with each other. Alternatively, a solvent in which an organic molecule is dissolved can be selected, and a polymer, which is dissolved in the solvent, is selected according to the property of the solvent.

In the method of the present invention, if the first electrode is an anode and the second electrode is a cathode, the first intermediate layer is used as a hole transferring layer or an electron blocking layer. Furthermore, the polymer of the present invention is used for providing the film-formation property and the organic molecule contributes the desired optoelectronic property. Thus, the organic molecule is selected from hole transferring materials when the first intermediate layer is used as a hole transferring layer, and the organic molecule is selected from electron blocking materials when the first intermediate layer is used as an electron blocking layer.

Similarly, when the second intermediate layer is used as an electron transferring layer or a hole blocking layer, the organic molecule is an electron transferring material and a hole blocking material respectively.

The active layer of the present invention can be fabricated by any appropriate materials and methods. For example, thin film layers can be formed by vacuum evaporation when molecules are used. Alternatively, thin films with large area can be fabricated by a solution process when polymer materials are used. In the present invention, preferably, polymer materials are used for fabricating active layers. Additionally, a solvent or a method for fabrication causing no damage to the first intermediate layer is selected when a solution process is performed.

In another aspect of the present invention, a method for fabricating an organic optoelectronic component may further comprise the steps of: applying onto the active layer a second mixture which is dissolved in a second solvent and includes a second polymer and at least a second organic molecule, so as to form a second intermediate layer on the active layer, prior to forming the second electrode on the second intermediate layer; wherein the at least a second organic molecule is the one for forming hole transferring material, electron transferring material, electron blocking material or hole blocking material. The active layer is made of a material insoluble in the second solvent so as to prevent the influence on the desired optoelectronic performance caused by damage to a thin film of the active layer. For example, when certain hole blocking layers can be dissolved in alcohol solvents and the active layer cannot, the polymer such as, but not limited to polyvinylpyrrolidone (PVP), polyvinyl alcohol (PVA), polyethylene oxide (PEO), polyethylene glycol (PEG) etc. soluble in the alcohol solvents can be selected, so that the organic molecule as the hole blocking layer and the polymer providing the film-formation property form a miscible solution. Additionally, the preformed active layer or other layers cannot be damaged during the formation of the intermediate layer since the active layer is insoluble in the alcohol solvents. Furthermore, the intermediate layer can be formed by using any solvents and unique processes such as scraper process without causing damage to the active layer.

In the method of the present invention, a first intermediate layer is formed by coating a first electrode with a first mixture. Similarly, a desired thin film of a second intermediate layer is formed by coating a surface of an active layer with a second mixture. Examples of coating include, but are not limited to spin coating, scraper coating, etc.

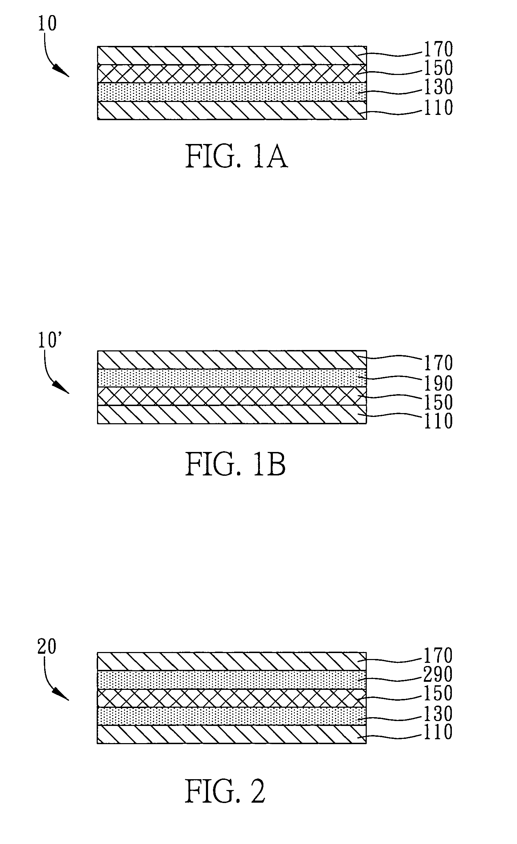

As shown in FIG. 1A, according to the method of the present invention, the present invention provides an organic optoelectronic component (10), which includes a first electrode (110); a first intermediate layer (130) formed on the first electrode (110); an active layer (150) formed on the first intermediate layer (130) to sandwich the first intermediate layer (130) in between the first electrode (110) and the active layer (150); and a second electrode (170) formed on the active layer (150) to sandwich the active layer (150) in between the first intermediate layer (130) and the second electrode (170); wherein the first intermediate layer (130) includes a first mixture containing a first polymer and a first organic molecule, and the first organic molecule is one for forming hole transferring material, electron transferring material, electron blocking material or hole blocking material.

Referring to FIG. 1B, another organic optoelectronic component (10') of the present invention includes a first electrode (110); an active layer (150) formed on the first electrode (110); a second intermediate layer (190) formed on the active layer (150) to sandwich the active layer (150) in between the first electrode (110) and the second intermediate layer (190); and a second electrode (170) formed on the second intermediate layer (190) to sandwich the second intermediate layer (190) in between the active layer (150) and the second electrode (170); wherein the second intermediate layer (190) includes a second mixture containing a second polymer and at least a second organic molecule, and the at least a second organic molecule is one for forming hole transferring material, electron transferring material, electron blocking material or hole blocking material.

FIG. 2 illustrates an organic optoelectronic component (20) in another aspect of the present invention. Besides the first intermediate layer (130), the optoelectronic component (20) further includes a second intermediate layer (290) formed between the active layer (150) and the second electrode (170), wherein the second intermediate layer (290) includes a second mixture containing a second polymer and at least a second organic molecule, and the at least a second organic molecule is one for forming hole transferring material, electron transferring material, electron blocking material or hole blocking material and is different from the at least a first organic molecule.

According to the present invention, the electrodes may include metals or metal substitutes. The metals are materials containing metal elements or materials containing metal alloys, wherein the metal alloys contain two or more metals. The metal substitutes are materials having the metalloid property, but are not well-defined metals, for example, doped semiconductors or transparent conductive oxides such as indium tin oxide (ITO). In general, ITO is used as an anode. Cathodes can be composed of one metal layer or two metal layers such as Ca/Al, Ca/Ag, Ba/Ag etc. Certainly, cathodes also can be composed of two or more layers of metal salts in combination with metals, such as LiF/Al, LiF/Ca/Al, CsF/Al, etc., and the metal salts are disposed between the active layer (or the intermediate layer) and the cathode.

In an embodiment, a first intermediate layer and a second intermediate layer are both provided. In such a case, the first intermediate layer is a hole transferring layer and the second intermediate layer is an electron transferring layer or a hole blocking layer. Alternatively, the first intermediate layer is an electron blocking layer and the second intermediate layer is an electron transferring layer or a hole blocking layer. In the embodiment, the first electrode is an anode and the second electrode is a cathode when the first intermediate layer is a hole transferring layer or an electron blocking layer or the second intermediate layer is an electron transferring layer or a hole blocking layer. On the other hand, the first intermediate layer may include a hole transferring sub-layer and an electron blocking sub-layer at the same time, or include an electron transferring sub-layer and a hole blocking sub-layer at the same time. For example, in an aspect that the present invention has a plurality of sub-layers, the first intermediate layer may comprise a poly(3,4-ethylenedioxythiophene)/poly(styrene sulfonate) (PEDOT:PSS) layer contacting the anode and used for facilitating hole transfer and modifying the surface, and other sub-layers can be hole transferring layers or electron blocking layers having polymers and organic molecules as described in the present invention.

In an embodiment of the organic optoelectronic component of the present invention, examples of the polymers are not particularly limited and any polymers having the film-formation property are the appropriate materials. Generally, the polymers (include the first polymer and the second polymer) have number average molecular weights ranging from 1,000 to 5,000,000. On the other hand, the organic molecules have molecular weights ranging from 50 to 1,000. The first and the second organic molecules in the organic optoelectronic component having a first and a second intermediate layers both have molecular weights ranging from 50 to 1,000.

In addition, although polymers used in the present invention are the materials having the film-formation property without the optoelectronic property, polymers having the optoelectronic property can also be selected by those skilled in the art after reading the present invention. Specifically, the first polymer is selected from hole transferring materials, electron transferring materials, electron blocking materials and hole blocking materials. Alternatively, in an organic optoelectronic component having a second intermediate layer, the first polymer is selected from hole transferring materials and electron blocking materials while the second polymer is selected from electron transferring materials and hole blocking materials.

An amount of the organic molecule in an intermediate layer of the organic optoelectronic component of the present invention is very important to allow the intermediate layer to generate the desired performance. For example, in an organic optoelectronic component having one intermediate layer, the amount of the first organic molecule is 30-95 wt% based on the weight of the first mixture including the first polymer and the first organic molecule. Preferably, the amount of the first organic molecule is 50-90 wt%. Similarly, in an organic optoelectronic component having a second intermediate layer, the amount of the second organic molecule is 30-95 wt% based on the weight of the second mixture. Preferably, the amount of the second organic molecule is 50-90 wt%.

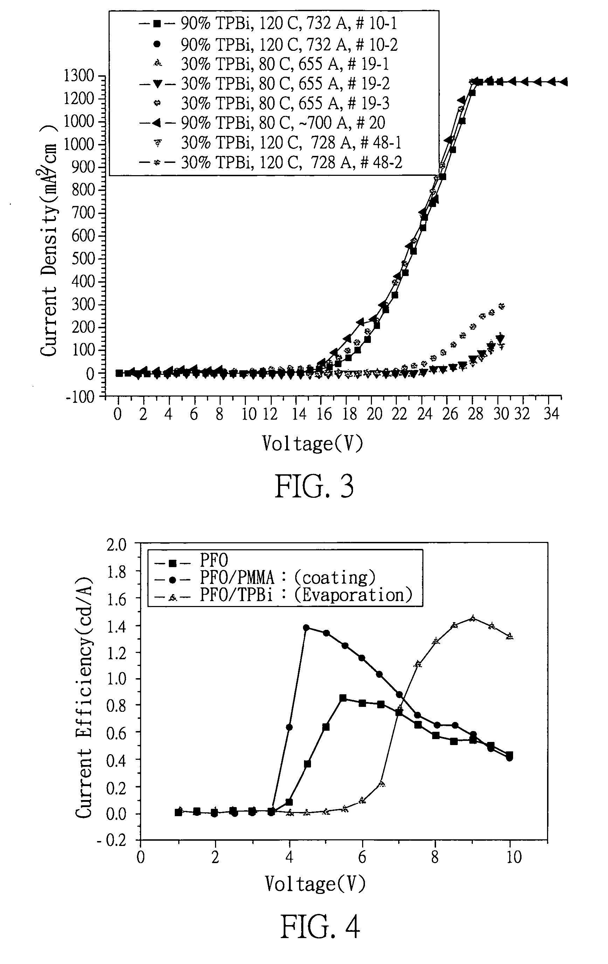

More specifically, as shown in FIG. 3, in an embodiment, 2-(4-biphenylyl)-5-(4-tert-butylphenyl)-1,3,4-oxadiazole (PBD) is used as the organic molecule and polyvinylpyrrolidone (PVP) is used as a matrix. The matrix containing the organic molecule is film-formed between the anode and the cathode by coating, the component is made and the current density thereof is tested. A desired current density is obtained when PBD is used in 30 wt% in the present invention. Preferably, an amount of the organic molecules is more than 50 wt%, and more preferably 70 wt%. In another aspect, in consideration of the film-formation property, the amount of the organic molecule is less than 95 wt%, and preferably less than 90 wt%. Furthermore, although FIG. 3 shows an illustrative example in which PBD is used as the organic molecule, other examples in which different organic molecules are used have similar current density and film-formation property. In addition, all numerical ranges are inclusive and combinable in any order.

The present invention is illustrated in detail by the following examples of organic optoelectronic components, but the material, thickness and concentration of each layer are not used to limit the scope of the present invention.

In an example of the present invention, operating voltage, current density and current efficiency of components are tested by using the hole transferring materials with different concentration ratios.

### Example 1

In the first example of the present invention, the first electrode is an anode, the organic molecule as the hole blocking material and the second intermediate layer is 1,3,5-tris(N-phenylbenzimidazol-2-yl)benzene (TPBi), the polymer used in the second intermediate layer is poly(methyl methacrylate) (PMMA) with a number average molecular weight of about 1,000,000, the active layer is formed of poly(9,9-dioctylfluorene) (PFO), and the second electrode is a cathode. The fabrication is performed as follows:

After indium tin oxide (ITO) with a thickness of 150 nm was formed on a glass substrate with a thickness of 0.7 nm as a first electrode (anode), PFO with a thickness of 80 nm was evaporated on the first electrode by thermal evaporation as an active layer or other polymer materials can be selected to form thin films by a solution process as active layers. Then, 30 mg of PMMA and 70 mg of TPBi were dissolved in toluene respectively, and a second mixture containing PMMA and TPBi was coated on the active layer by scraper coating. The active layer would not be damaged by the second mixture since the material of the active layer is insolvent in the solvent. After that, vacuum drying at 50°C was carried out for 1 hr to remove the solvent and form the second intermediate layer. Finally, a second electrode (cathode) made of aluminum with a thickness of 100 nm was formed by thermal evaporation.

### Comparative Example 1

The method of Example 1 was repeated, but the second intermediate layer was formed by evaporating TPBi only on the active layer.

After ITO with a thickness of 150 nm was formed on a glass substrate with a thickness of 0.7 nm as a first electrode (anode), poly(9,9-dioctylfluorene) with a thickness of 60 nm was spin coated on the first electrode by thermal evaporation as an active layer. Then, TPBi was evaporated on the active layer to form the second intermediate layer. Finally, a second electrode (cathode) made of cesium fluoride with a thickness of 2 nm and aluminum with a thickness of 100 nm was formed by thermal evaporation.

As shown in FIG. 4, a light-emitting component of the present invention including a polymer and an organic molecule has the current efficiency equivalent to that of an component of Comparative Example 1 having a hole blocking layer formed by evaporation. Furthermore, the light-emitting component of Example 1 of the present invention has higher current efficiency, compared to the component containing no hole blocking layers.

### Example 2

The method of Example 1 was repeated, but the organic molecule of the second intermediate layer was 2-(4-biphenylyl)-5-(4-tert-butylphenyl)-1,3,4- oxadiazole (PBD) as a hole blocking material, the polymer of the second intermediate layer is polyvinylpyrrolidone (PVP) with a number average molecular weight of 360,000, and polyfluorene (PFO) was used as a material for the active layer.

After ITO with a thickness of 150 nm was formed on a glass substrate with a thickness of 0.7 nm as a first electrode (anode), PFO with a thickness of 60 nm was coated on the first electrode by spin coating as an active layer or other polymer materials can be selected to form thin films by a solution process as active layers. Then, 50 mg of PVP and 50 mg of PBD were dissolved in 10 ml of n-butanol respectively, and a second mixture containing PVP and PBD was coated on the active layer by spin coating. The active layer would not be damaged by the second mixture since the material of the active layer is insoluble in the solvent. After that, vacuum drying at 50°C was carried out for 30 minutes to remove the solvent and form the second intermediate layer. Finally, a second electrode (cathode) made of cesium fluoride with a thickness of 2 nm and aluminum with a thickness of 100 nm was formed by thermal evaporation.

### Comparative Example 2

After ITO with a thickness of 150 nm was formed on a glass substrate with a thickness of 0.7 nm as a first electrode (anode), PFO with a thickness of 60 nm was coated on the first electrode by spin coating as an active layer. Finally, a second electrode (cathode) made of aluminum with a thickness of 100 nm was formed by thermal evaporation.

### Comparative Example 3

The method of Example 2 was repeated, but the second intermediate layer was formed by evaporating PBD only on the active layer.

After ITO with a thickness of 150 nm was formed on a glass substrate with a thickness of 0.7 nm as a first electrode (anode), PFO with a thickness of 60 nm was coated on the first electrode by spin coating as an active layer. Then, PBD was evaporated on the active layer to form a second intermediate layer. Finally, a second electrode (cathode) made of aluminum with a thickness of 100 nm was formed by thermal evaporation.

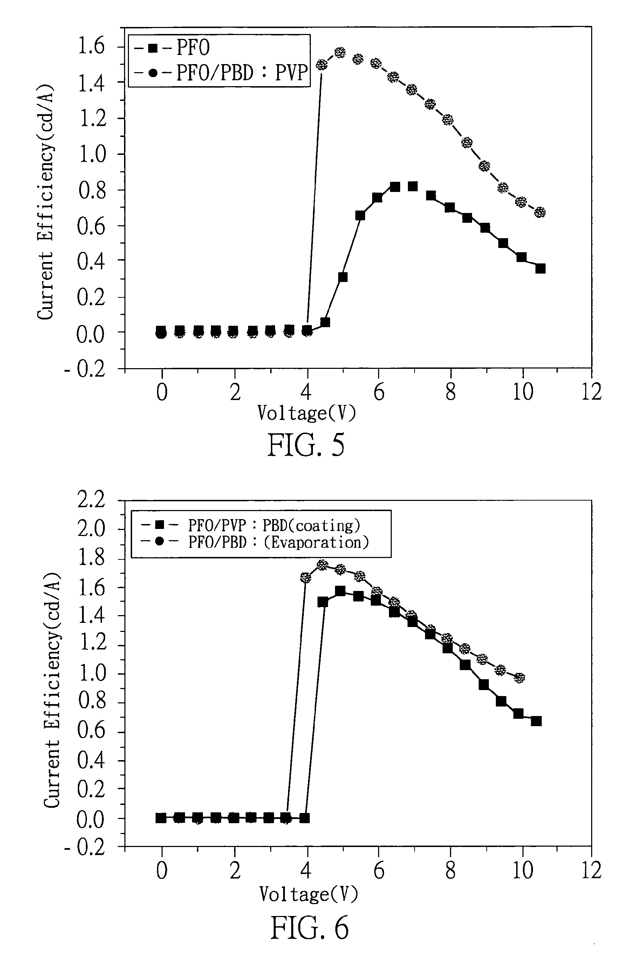

As shown in FIG. 5, a organic light-emitting component of the present invention having a polymer and an organic molecule has current efficiency 2-fold higher than that of the organic light-emitting component of comparative example 2 with a single layer. In another aspect, as shown in FIG. 6, the organic light-emitting component of the present invention having a polymer and an organic molecule has current efficiency equivalent to that of an organic light-emitting component of Comparative Example 3 having the second intermediate layer made of PBD only.

The foregoing descriptions of the specific embodiments are only illustrated to disclose the features and functions of the present invention and not restrictive of the scope of the present invention. Persons skilled in the art should understand that all modifications and variations made in the present invention according to the spirit and principle in the disclosure of the present invention should fall within the scope of the appended claims.

## Claims

1. An organic optoelectronic component, comprising:
a first electrode;
an active layer formed on the first electrode;
a second intermediate layer formed on the active layer, allowing the active layer to be interposed between the first electrode and the second intermediate layer; and
a second electrode formed on the second intermediate layer, allowing the second intermediate layer to be interposed between the active layer and the second electrode,
wherein the second intermediate layer is formed with a second mixture containing a second polymer and at least a second organic molecule, and the at least a second organic molecule is one for forming hole transferring material, electron transferring material, electron blocking material or hole blocking material.

2. The organic optoelectronic component of claim 1, further comprising a first intermediate layer formed between the active layer and the first electrode, wherein the first intermediate layer is formed with a first mixture containing a first polymer and at least a first organic molecule, and the at least a first organic molecule is one for forming hole transferring material, electron transferring material, electron blocking material or hole blocking material, and the second organic molecule is different from the first organic molecule.

3. The organic optoelectronic component of claim 2, wherein the first intermediate layer is a hole transferring layer and the second intermediate layer is one of an electron transferring layer and a hole blocking layer.

4. The organic optoelectronic component of claim 2 or 3, wherein the first intermediate layer is an electron blocking layer and the second intermediate layer is one of an electron transferring layer and a hole blocking layer.

5. The organic optoelectronic component of any of claims 2 to 4, wherein the first polymer is one for forming hole transferring material or electron blocking material, and the second polymer is one for forming hole blocking material or electron transferring material.

6. The organic optoelectronic component of any of claims 1 to 5, wherein the second organic molecule is 30-95 wt% of the second mixture.

7. The organic optoelectronic component of any of claims 2 to 6, wherein the first organic molecule is 30-95 wt% of the first mixture.

8. An organic optoelectronic component, comprising:
a first electrode;
a first intermediate layer formed on the first electrode;
an active layer formed on the first intermediate layer, allowing the first intermediate layer to be interposed between the first electrode and the active layer; and
a second electrode formed on the active layer, allowing the active layer to be interposed between the first intermediate layer and the second electrode,
wherein the first intermediate layer is formed with a first mixture containing a first polymer and a first organic molecule, the first organic molecule is one for forming hole transferring material, electron transferring material, electron blocking material or hole blocking material, and the first organic molecule is 30-95 wt% of the first mixture.

9. The organic optoelectronic component of claim 8, wherein the first organic molecule is of molecular weight ranging from 50 to 1,000.

10. A method for fabricating an organic optoelectronic component, comprising the steps of:
applying onto a first electrode a first mixture which is dissolved in a first solvent and comprises a first polymer and a first organic molecule, allowing the first mixture to form a first intermediate layer on the first electrode;
removing the first solvent from the first intermediate layer, followed by forming an active layer on the first intermediate layer; and
forming a second electrode on the active layer, allowing the active layer to be interposed between the first intermediate layer and the second electrode,
wherein the first organic molecule is one for forming hole transferring material, electron transferring material, electron blocking material or hole blocking material.

11. The method of claim 10, further comprising the steps of:
applying onto the active layer a second mixture which is dissolved in a second solvent and comprises a second polymer and at least a second organic molecule, so as to form a second intermediate layer on the active layer, prior to forming the second electrode on the second intermediate layer; and
wherein the at least a second organic molecule is the one for forming hole transferring material, electron transferring material, electron blocking material and or blocking material.

12. The method of claim 10 or 11, wherein the active layer is made of a material insoluble in the first solvent.

13. A method for fabricating an organic optoelectronic component, comprising the steps of:
forming an active layer on a first electrode;
applying onto the active layer a second mixture which is dissolved in a second solvent and comprises a second polymer and at least a second organic molecule, so as for the second mixture to form a second intermediate layer on the active layer, wherein the at least a second organic molecule is one for forming hole transferring material, electron transferring material, electron blocking material or hole blocking material; and
forming a second electrode on the second intermediate layer.

14. The method of claim 13, further comprising the steps of:
applying onto the first electrode a first mixture which is dissolved in a first solvent and comprises a first polymer and at least a first organic molecule, so as to form a first intermediate layer on the first electrode prior to forming the active layer on the first intermediate layer.

15. The method of claim 13 or 14, wherein the active layer is made of a material insoluble in the second solvent.
